# EUROPEAN PATENT APPLICATION

(11) **EP 4 124 678 A1**
(43) Date of publication of application: **01.02.2023**
(21) Application number: 22185760.0
(22) Date of filing: 19.07.2022
(51) Int. Cl.: C25D 5/00, C25D 7/00, H01L 23/495, C25D 3/46

(54) **METAL COMPONENT**

(30) Priority: 28.07.2021 JP 2021123496
(71) Applicant: Mitsui High-Tec, Inc., Kitakyushu-shi, Fukuoka 807-8588 (JP)
(72) Inventor: KUBO, Kimihiko, Fukuoka, 807-8588 (JP); FURUNO, Ryota, Fukuoka, 807-8588 (JP)
(74) Representative: Stöckeler, Ferdinand

(57) **Abstract**

Provided is a metal component that is configured to be used for manufacturing a semiconductor device, the metal component including: a substrate having a conductivity; and a noble metal plating layer formed on all or part of a surface of the substrate, wherein the noble metal plating layer has a surface with irregularities, and a protrusion of the irregularities has an aspect ratio of 0.3 or more.

## Description

### BACKGROUND

### 1. Technical Field

The present disclosure relates to a metal component.

### 2. Related Art

Conventionally, a technique for forming a noble metal plating layer on the metal component such as a lead frame used for manufacturing a semiconductor device has been known. This plating layer is formed on a part or all of a surface of a metal substrate of the metal component. Among them, the metal component having an Ag plating layer formed on a part of the metal substrate mainly made of Cu is widely employed in the semiconductor device that requires reliability because of high heat dissipation and conductivity (see JP-A-05-003277).

### SUMMARY

A metal component according to an embodiment of the present disclosure is configured to be used for manufacturing a semiconductor device, and includes: a substrate having a conductivity; and a noble metal plating layer formed on all or part of a surface of the substrate. The noble metal plating layer has a surface with irregularities, and a protrusion of the irregularities has an aspect ratio of 0.3 or more.

### BRIEF DESCRIPTION OF DRAWINGS

Fig. 1A is a schematic diagram of a lead frame used in the present embodiment;
Fig. 1B is a cross-sectional view of a semiconductor device used in the present embodiment;
Fig. 2 is an enlarged cross-sectional view of the lead frame used in the present embodiment;
Fig. 3 describes a test sample used for a shear strength test;
Fig. 4A illustrates shear strength of lead frames used in Comparative Examples 1 and 2 and Example 1 in a room temperature environment;
Fig. 4B illustrates the shear strength of the lead frames used in Comparative Examples 1 and 2 and Example 1 in a high temperature environment;
Fig. 5A illustrates a relationship between the shear strength and surface roughness Ra of the lead frames used in Comparative Example 2 and Examples 2 to 6 in the high temperature environment;
Fig. 5B illustrates a relationship between the shear strength and a surface area increase rate of the lead frames used in Comparative Example 2 and Examples 2 to 6 in the high temperature environment;
Fig. 6 illustrates a relationship between the shear strength and an aspect ratio of the lead frames used in Comparative Example 2 and Examples 2 to 6 in the high temperature environment;
Fig. 7 illustrates a correlation between the aspect ratio and the shear strength in the high temperature environment of the lead frame used in the present embodiment;
Fig. 8 illustrates surface morphology and cross-sectional morphology of a plating layer formed on the lead frame used in Comparative Example 3 before and after heat treatment;
Fig. 9 illustrates the surface morphology and the cross-sectional morphology of the plating layer formed on the lead frame used in Example 2 before and after the heat treatment; and
Fig. 10 illustrates a variation of the shear strength due to thermal history of the lead frame used in Example 1.

### DETAILED DESCRIPTION

In the following detailed description, for purpose of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

A semiconductor device includes a semiconductor element, a metal component, and the like sealed with a resin. Therefore, there is an interface between the metal and the resin. The metal and the resin have very different coefficients of thermal expansion. Therefore, stress increases at the interface between the metal and the resin due to heat generated during mounting or driving. Then, adhesive strength between such a sealing resin and the plating layer may be reduced. Thus, there is a possibility that peeling may occur between the sealing resin and the plating layer. In such a case, reliability of the semiconductor device is reduced.

One aspect of the present embodiment has been made in view of the above problems. That is, an object of the present disclosure is to provide a metal component capable of improving the reliability of the semiconductor device in a high temperature environment.

The metal component according to one aspect of the present embodiment is used for manufacturing the semiconductor device. The metal component includes a conductive substrate and a noble metal plating layer formed on all or part of a surface of the substrate. Further, the noble metal plating layer has a surface with irregularities. Then, a protrusion of the irregularities has an aspect ratio of 0.3 or more.

According to one aspect of the present embodiment, the reliability of the semiconductor device in the high temperature environment can be improved.

Hereinafter, a lead frame will be described as an example of the metal component according to the present embodiment used for manufacturing the semiconductor device with reference to the attached drawings. Note that the present embodiment is not limited to an embodiment described below.

In addition, the drawings are schematic drawings. It should be noted that relationships, ratios, and the like between dimensions of elements may differ from actual dimensions of the elements. Further, also among the drawings, the relationships or ratios between the dimensions of the same portions may be different from each other.

Conventionally, in the metal component such as the lead frame used for manufacturing the semiconductor device, a technique for forming the noble metal plating layer such as an Ag plating layer on a part or all of a surface of a metal substrate is known. The Ag plating layer formed on the surface of the metal substrate can improve bonding strength between the metal substrate and the semiconductor element and the bonding strength between the metal substrate and a bonding wire. Therefore, the reliability of the semiconductor device can be improved.

Among them, the lead frame having the Ag plating layer formed on a part of the surface of the metal substrate mainly made of Cu has high heat dissipation and conductivity. Therefore, such a lead frame is widely employed in the semiconductor device that requires reliability.

The semiconductor device includes the semiconductor element, the metal component, and the like sealed with a resin. Therefore, there is an interface between the metal and the resin. The metal and the resin have very different coefficients of thermal expansion. Therefore, stress increases at the interface between the metal and the resin due to heat generated during mounting or driving.

In particular, solder reflow temperature during mounting is higher than a glass transition temperature of the resin. Such a reflow temperature extremely reduces the adhesive strength between the sealing resin and the metal component. Thus, the noble metal plating layer having a low adhesive strength with the resin cannot withstand the stress, and there is a possibility that the peeling may occur between the noble metal plating layer and the sealing resin. In such a case, the reliability of the semiconductor device is reduced.

Therefore, in order to overcome the above-mentioned problems, it is expected to realize a technique capable of improving the reliability of the semiconductor device in the high temperature environment.

### <Lead frame and semiconductor device>

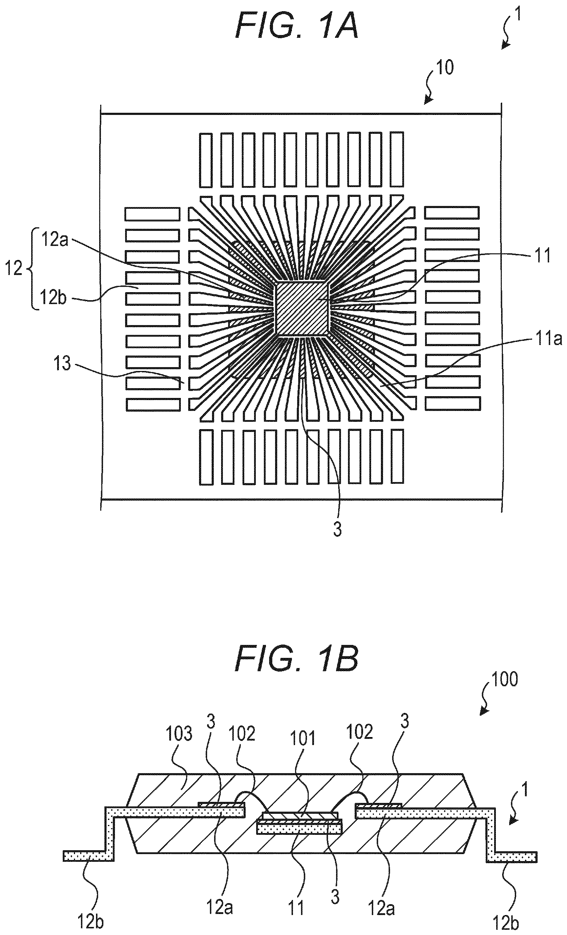

First, a lead frame 1 and a semiconductor device 100 used in the present embodiment will be described with reference to Figs. 1A and 1B. Fig. 1A is a schematic diagram of the lead frame 1 according to the present embodiment. Fig. 1B is a cross-sectional view of the semiconductor device 100 used in the present embodiment.

The lead frame 1 illustrated in Fig. 1A is a lead frame used for manufacturing a quad flat package (QFP) type semiconductor device 100. Note that the present embodiment may be applied to the lead frame used for manufacturing other types, for example, a small outline package (SOP) semiconductor device, or a quad flat non-leaded package (QFN) semiconductor device having a lead exposed on a back surface thereof.

The lead frame 1 used in the present embodiment has, for example, a strip shape in a plan view. In the lead frame 1, a plurality of unit lead frames 10 are formed side by side in a longitudinal direction of the lead frame 1. Such a unit lead frame 10 is a portion corresponding to each of semiconductor devices 100 manufactured by using the lead frame 1. It should be noted that the unit lead frames 10 may be formed side by side not only in the longitudinal direction of the lead frame 1 but also in a width direction of the lead frame 1.

As illustrated in Fig. 1A, the unit lead frame 10 includes a die pad 11, a plurality of leads 12, and a dam bar 13. Note that although not illustrated in Fig. 1A, pilot holes may be provided side by side on a side surface on a long side of the lead frame 1.

The die pad 11 is provided, for example, in a central portion of the unit lead frame 10. As illustrated in Fig. 1B, a semiconductor element 101 can be mounted on a front surface side of the die pad 11.

The die pad 11 is connected to an outer edge portion of the unit lead frame 10 by a die pad support portion 11a. In this way, the die pad 11 is supported by the unit lead frame 10. The die pad support portion 11a is provided, for example, at each of four corners of the die pad 11.

The leads 12 are arranged side by side around the die pad 11. Each of tip portions 12a extends from the outer edge portion of the unit lead frame 10 toward the die pad 11. As illustrated in Fig. 1B, the lead 12 functions as a connection terminal of the semiconductor device 100.

The lead 12 includes a tip portion 12a and a base end portion 12b. As illustrated in Fig. 1B, in the semiconductor device 100, a bonding wire 102 made of Cu, a Cu alloy, Au, an Au alloy, or the like is connected to the tip portion 12a of the lead 12. Therefore, the lead frame 1 is required to have high bonding characteristics with the bonding wire 102. The dam bar 13 connects adjacent leads 12 to each other.

The semiconductor device 100 includes a sealing resin 103 in addition to the lead frame 1, the semiconductor element 101, and the bonding wire 102. The sealing resin 103 is made of, for example, an epoxy resin or the like. The sealing resin 103 is molded into a predetermined shape by a molding process or the like. The sealing resin 103 seals the semiconductor element 101, the bonding wire 102, a surface of the die pad 11, the tip portion 12a of the lead 12, and the like.

Further, the base end portion 12b of the lead 12 functions as an external terminal (outer lead) of the semiconductor device 100. The semiconductor device 100 is solder-bonded to a substrate at the base end portion 12b. Further, the semiconductor device 100 of the type having a back surface of the die pad 11 exposed from the sealing resin 103 or the type having a heat slug provided on the back surface is solder-bonded to the substrate on the back surface thereof. Therefore, the lead frame 1 is required to have high wettability to solder.

Note that the dam bar 13 has a dam function for suppressing leakage of the resin used to the base end portion 12b (outer lead) side in the molding process of molding the sealing resin 103. The dam bar 13 is finally cut in a manufacturing process of the semiconductor device 100.

Here, in the lead frame 1 used in the present embodiment, a plating layer 3 is formed on the die pad 11 and the tip portion 12a of the lead 12. The plating layer 3 is an example of the noble metal plating layer. The plating layer 3 is made of, for example, Ag (silver) as a main component.

Thus, the bonding strength between the lead frame 1 and the bonding wire 102 can be improved. Further, the bonding strength between the lead frame 1 and the solder can be improved. Therefore, the bonding strength between the lead frame 1 and the semiconductor element 101 can be improved.

### <Details of lead frame>

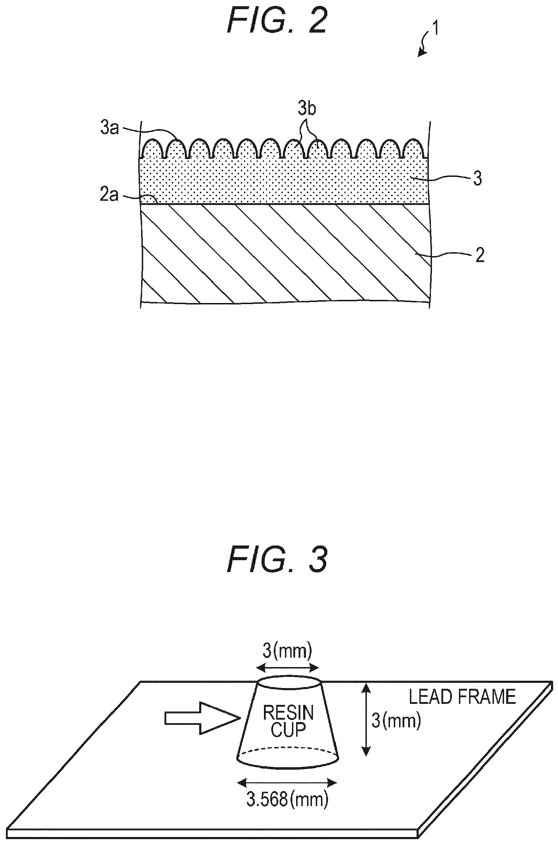

Subsequently, details of the lead frame 1 used in the present embodiment will be described with reference to Fig. 2. Fig. 2 is an enlarged cross-sectional view of the lead frame 1 used in the present embodiment.

As illustrated in Fig. 2, the lead frame 1 according to the present embodiment includes the substrate 2 and the plating layer 3. The substrate 2 is made of a conductive material (for example, a metal material such as copper, a copper alloy, or an iron-nickel alloy).

The plating layer 3 is formed on a surface 2a of the substrate 2. In the present embodiment, the plating layer 3 contains Ag as the main component. Further, as illustrated in Fig. 2, the plating layer 3 has a surface 3a with irregularities. That is, the surface 3a of the plating layer 3 has a plurality of protrusions 3b.

Note that at least one plating layer containing Cu, Ni, Pd, Au, Ag, or the like as the main component may be formed as a base plating layer between the substrate 2 and the plating layer 3 for the purpose of preventing metal diffusion or improving heat resistance. Further, the plating layer containing Au, Pt, Pd, Ag or the like as the main component may be formed on the surface of the plating layer 3.

Here, in the present embodiment, the protrusion 3b formed on the surface 3a of the plating layer 3 has an aspect ratio (that is, a ratio of a height of the protrusion 3b to a width of the protrusion 3b) of 0.3 or more. This can minimizes reduction in the adhesive strength between the sealing resin 103 and the plating layer 3 that occurs when the semiconductor device 100 is exposed to the high temperature environment (for example, when it is mounted on a printed circuit board or the like in a reflow process).

Therefore, according to the present embodiment, the reliability of the semiconductor device 100 in the high temperature environment can be improved.

Further, in the present embodiment, the protrusion 3b formed on the surface 3a of the plating layer 3 preferably has an aspect ratio of 0.5 or more. Thus, it is possible to further suppress the reduction in the adhesive strength between the sealing resin 103 and the plating layer 3 that occurs when the semiconductor device 100 is exposed to the high temperature environment.

Therefore, according to the present embodiment, the reliability of the semiconductor device 100 in the high temperature environment can be further improved.

Note that in the present embodiment, the protrusion 3b formed on the surface 3a of the plating layer 3 preferably has an aspect ratio of 1.2 or less. Thus, the plating layer 3 having irregularities on the surface 3a can be easily formed, so that the manufacturing cost of the lead frame 1 can be reduced.

Further, in the present embodiment, when the plating layer 3 formed on the substrate 2 is heated to 260°C for sealing with the sealing resin 103, a shear strength between the plating layer 3 and the sealing resin 103 is preferably 2MPa or more.

In this way, the adhesive strength (that is, the shear strength) between the sealing resin 103 and the plating layer 3 when the semiconductor device 100 is exposed to the high temperature environment is set to a predetermined value or more. This can further improve the reliability of the semiconductor device 100 in the high temperature environment.

Further, in the present embodiment, when the plating layer 3 formed on the substrate 2 is heated to 260°C for sealing with the sealing resin 103, the shear strength between the plating layer 3 and the sealing resin 103 is preferably 10% or more of the shear strength between the plating layer 3 and the sealing resin 103 before heating.

In this way, a residual ratio of the adhesive strength (that is, shear strength) between the sealing resin 103 and the plating layer 3 when the semiconductor device 100 is exposed to the high temperature environment is set to a predetermined ratio or more. This can further improve the reliability of the semiconductor device 100 in the high temperature environment.

Further, in the present embodiment, pull strength is preferably 5.0 g or more in a stitch pull strength test using the plating layer 3. The stitch pull strength test is a test in which the bonding strength between the plating layer 3 and the bonding wire 102 is measured as the pull strength. According to the present embodiment, the bonding strength measured by the stitch pull strength test is set to a predetermined value or more. This can further improve the reliability of the semiconductor device 100.

### [Examples]

Hereinafter, the present embodiment will be described in more detail with reference to Examples and Comparative Examples. However, the present embodiment is not limited to the following examples.

### <Evaluation 1>

### [Example 1]

First, a lead frame substrate containing copper as a main component was prepared. Next, the substrate was degreased and washed with acids. Thereafter, by an electroplating treatment, an Ag plating layer was formed on a surface of the substrate.

A plating bath used for the electroplating treatment was made up by adding K(AgCN₂): 120 g/L and a roughening additive: 80 ml/L to a bath mainly containing a conductive salt such as a nitrate or an organic acid salt. Then, the Ag plating layer having a thickness of 5 µm was formed under electroplating treatment conditions of bath temperature: 61°C and current density: 70 A/dm².

By the electroplating treatment under such conditions, the Ag plating layer having a surface with irregularities was formed. Further, the aspect ratio of the protrusion of the irregularities was 0.55. Thus, a lead frame of Example 1 was obtained.

In the present disclosure, the aspect ratio of the protrusion formed on the surface was measured in a room temperature environment using a shape analysis laser microscope VK-X210 manufactured by KEYENCE CORPORATION. Further, an average value of N = 20 was defined as a value of the aspect ratio.

### [Examples 2 to 14]

By the same method as in Example 1 described above, lead frames of Examples 2 to 14 including the Ag plating layer having irregularities formed on the surface were obtained. Note that in Examples 2 to 14, the electroplating treatment conditions were appropriately adjusted so that values of aspect ratios of the protrusions formed on the Ag plating layer varied.

### [Comparative Example 1]

First, a lead frame substrate containing copper as the main component was prepared. Next, the substrate was degreased and washed with acids. Thus, the lead frame of Comparative Example 1 was obtained. That is, in Comparative Example 1, the Ag plating layer was not formed on a surface of the lead frame. In the lead frame, a copper substrate was directly exposed.

### [Comparative Example 2]

First, a lead frame substrate containing copper as a main component was prepared. Next, the substrate was degreased and washed with acids. Thereafter, by an electroplating treatment, an Ag plating layer was formed on a surface of the substrate.

A plating bath used for the electroplating treatment was made up by adding K(AgCN₂): 120 g/L to a bath mainly containing a conductive salt such as a nitrate or an organic acid salt. Then, the Ag plating layer having a thickness of 5 µm was formed under electroplating treatment conditions of bath temperature: 65°C and current density: 70 A/dm².

By the electroplating treatment under such conditions, the Ag plating layer having a smooth surface was formed. That is, in Comparative Example 2, the aspect ratio of the protrusion of the Ag plating layer was almost zero. Thus, the lead frame of Comparative Example 2 was obtained.

Subsequently, the shear strength of the lead frames of Examples 1 to 14 and Comparative Examples 1 and 2 obtained above was evaluated. Fig. 3 illustrates a test sample used in a shear strength test. First, as illustrated in Fig. 3, a resin cup made of an epoxy resin (EME-G631H) was formed on surfaces of the lead frames of Examples 1 to 14 and Comparative Examples 1 and 2.

The resin cup was molded under conditions of molding temperature: 180°C, molding time: 90 seconds, cure temperature: 180°C, and cure time: 4 hours.

Next, a cup shear test was performed according to a procedure specified by SEMI standard G69-0996. Specifically, a gauge (not illustrated) was pressed against the resin cup of each test sample. In this way, the resin cup was moved in a direction of an arrow in Fig. 3. Thus, the shear strength was measured. A height (shear height) of the gauge during such measurement was 100 µm. A gauge speed (shear speed) was 100 µm/s.

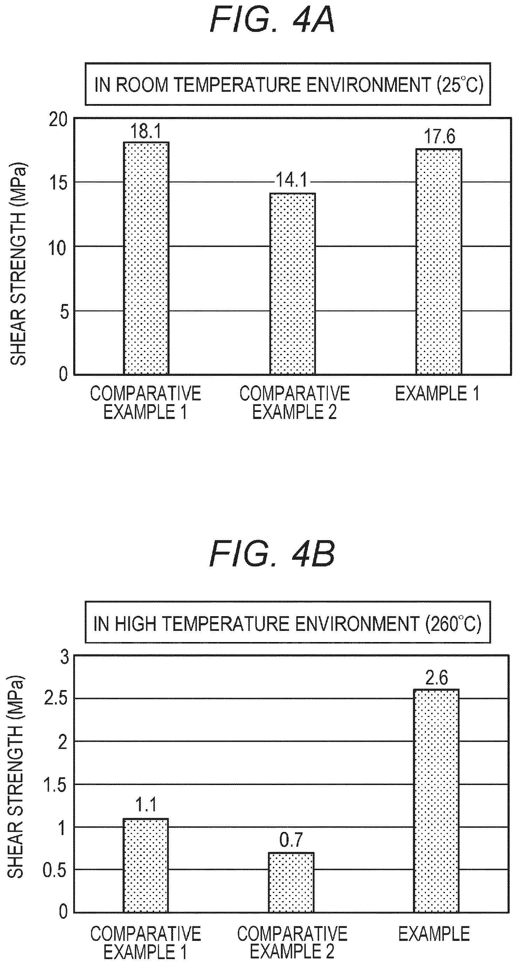

Fig. 4A illustrates the shear strength of the lead frames used in Comparative Examples 1 and 2 and Example 1 in the room temperature environment. As illustrated in Fig. 4A, by comparing Comparative Example 2 using a smooth Ag plating layer and Example 1 using the Ag plating layer including the protrusion having the aspect ratio of 0.3 or more, it was found that the shear strength of the lead frame of Example 1 was increased in the room temperature environment.

Therefore, according to the present embodiment, the reliability of the semiconductor device in the room temperature environment can be improved.

It should be noted that copper exhibits better adhesion to the sealing resin than silver. Therefore, as illustrated in Fig. 4A, the lead frame of Comparative Example 1 shows a good shear strength value in the room temperature environment.

Fig. 4B illustrates the shear strength of the lead frames according to Comparative Examples 1 and 2 and Example 1 in the high temperature environment. Such measurement results were obtained by the shear strength test performed in an environment of 260°C.

As illustrated in Fig. 4B, the shear strength of the lead frames of Comparative Examples 1 and 2 was significantly reduced in the high temperature environment. On the other hand, in the lead frame of Example 1, reduction in the shear strength is minimized.

Specifically, the shear strength of the lead frame of Comparative Example 1 in the high temperature environment is reduced to about 6% of the shear strength in the room temperature environment. Further, the shear strength of the lead frame of Comparative Example 2 in the high temperature environment is reduced to about 5% of the shear strength in the room temperature environment. On the other hand, the shear strength of the lead frame of Example 1 in the high temperature environment is only reduced to about 15% of the shear strength in the room temperature environment.

As described above, according to a comparison between Comparative Examples 1 and 2 and Example 1, in the lead frame of Example 1, the reduction in the adhesive strength between the sealing resin and the plating layer in the high temperature environment is minimized. Therefore, according to the present embodiment, the reliability of the semiconductor device in the high temperature environment can be improved.

Subsequently, surface roughness Ra and surface area increase rate of the lead frames of Examples 2 to 6 and Comparative Example 2 were evaluated. The surface roughness Ra and the surface area increase rate of the lead frames were measured in the room temperature environment using the shape analysis laser microscope VK-X210 manufactured by KEYENCE CORPORATION.

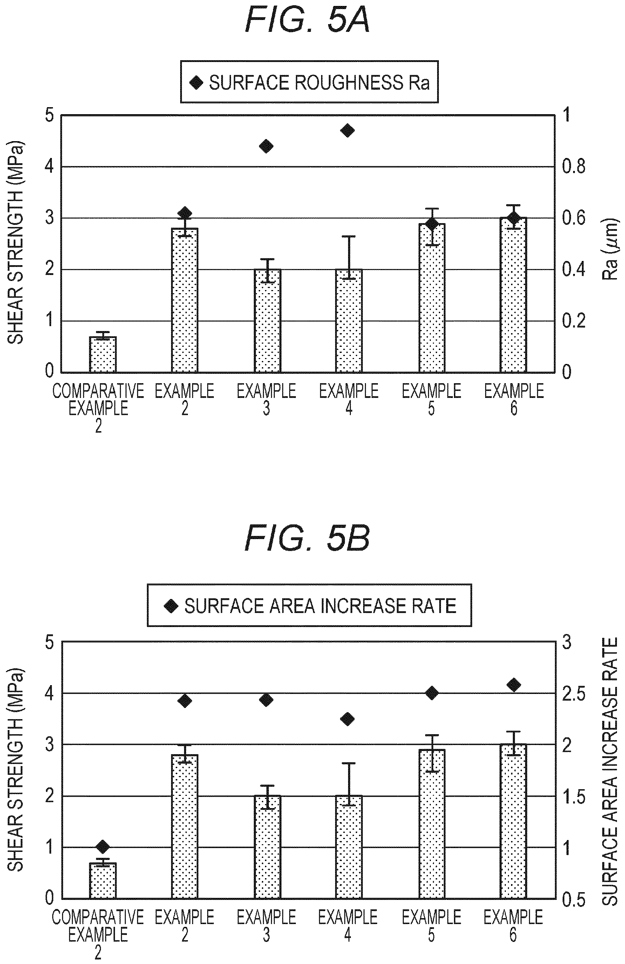

Fig. 5A illustrates a relationship between the shear strength and the surface roughness Ra in the high temperature environment (260°C) of the lead frames used in Comparative Example 2 and Examples 2 to 6. By comparing Examples 2 to 6 illustrated in Fig. 5A, it is found that the shear strength in the high temperature environment of some lead frames having a high surface roughness Ra of the plating layer is not increased.

That is, in the present embodiment, it was clarified that the surface roughness Ra and the shear strength in the high temperature environment of the plating layer have a low correlation.

Fig. 5B illustrates a relationship between the shear strength and the surface area increase rate of the lead frames used in Comparative Example 2 and Examples 2 to 6 in the high temperature environment (260°C). By comparing Examples 2 to 6 illustrated in Fig. 5B, it is found that the shear strength in the high temperature environment of some lead frames having a high surface area increase rate of the plating layer is not increased.

That is, in the present embodiment, it was clarified that the surface area increase rate and the shear strength in the high temperature environment of the plating layer have a low correlation.

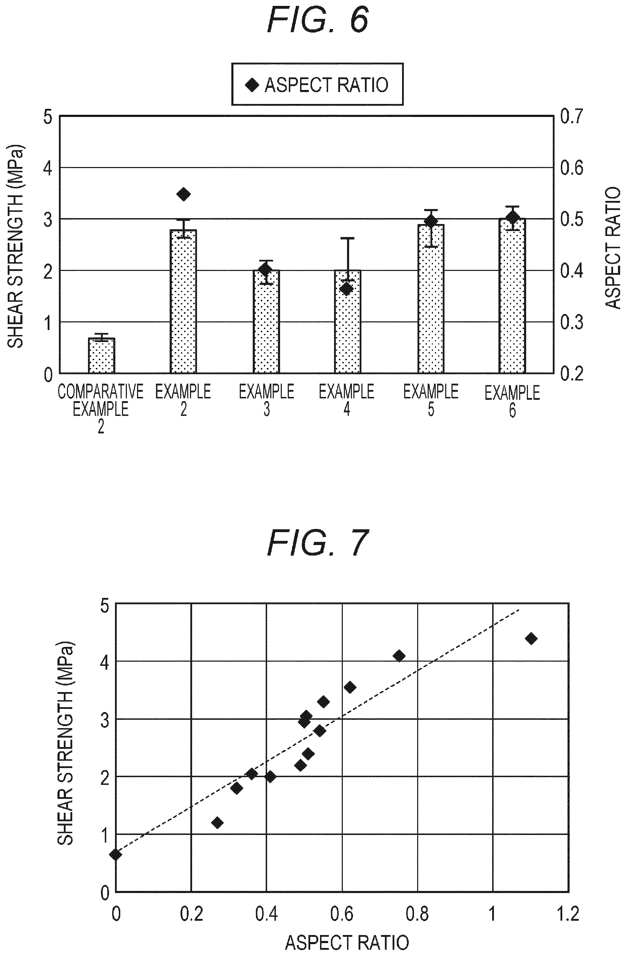

Fig. 6 illustrates a relationship between the shear strength and the aspect ratio in the high temperature environment of the lead frames used in Comparative Example 2 and Examples 2 to 6. By comparing Examples 2 to 6 illustrated in Fig. 6, it is found that the shear strength in the high temperature environment of the lead frame having a high aspect ratio of the protrusion formed on the plating layer is increased.

That is, in the present embodiment, it was clarified that the aspect ratio and the shear strength in the high temperature environment of the protrusion formed on the plating layer have a high correlation.

Fig. 7 illustrates a correlation between the aspect ratio and the shear strength in the high temperature environment of the lead frame used in the present embodiment. From results illustrated in Fig. 7, it was clarified that the aspect ratio and the shear strength in the high temperature environment of the protrusion formed on the plating layer have a high correlation.

As described above, in the present embodiment, surface morphology of the plating layer is modified by focusing on the aspect ratio of the protrusion rather than the surface roughness or the surface area increase rate of the plating layer.

Then, in the present embodiment, the plating layer including the protrusion having the aspect ratio of 0.3 or more is formed on the lead frame. This can increase the shear strength in the high temperature environment. Therefore, the reliability of the semiconductor device in the high temperature environment can be improved.

### <Evaluation 2>

### [Comparative Example 3]

First, a lead frame substrate containing copper as a main component was prepared. Next, the substrate was degreased and washed with acids. Thereafter, by an electroplating treatment, an Ag plating layer was formed on a surface of the substrate.

A plating bath used for the electroplating treatment was made up by adding K(AgCN₂): 120 g/L to a bath mainly containing a conductive salt such as a nitrate or an organic acid salt. Then, the Ag plating layer having a thickness of 5 µm was formed under electroplating treatment conditions of bath temperature: 65°C and current density: 90 A/dm².

By the electroplating treatment under such conditions, the Ag plating layer having a roughened (matte) surface was formed. Further, in the Ag plating layer of Comparative Example 3, the aspect ratio of the protrusion was less than 0.3. Thus, the lead frame of Comparative Example 3 was obtained.

Subsequently, the surface morphology and cross-sectional morphology near the surface of the lead frames of Comparative Example 3 and Example 2 obtained above were evaluated. A commercially available scanning electron microscope (SEM) (Hitachi Ultra-High Resolution Field Emission Scanning Electron Microscope S-4800 manufactured by Hitachi High-Tech Fielding Corporation) was used for the evaluation.

Note that the evaluation of the surface morphology and the cross-sectional morphology near the surface was performed before heat treatment and after a predetermined heat treatment (400°C, 10 minutes).

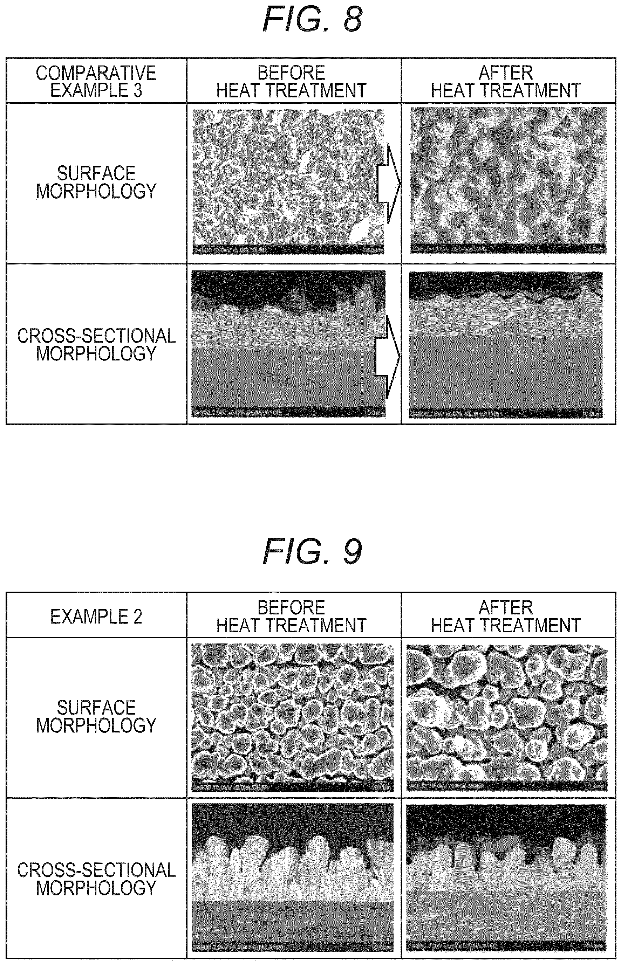

Fig. 8 illustrates the surface morphology and the cross-sectional morphology of the plating layer formed on the lead frame of Comparative Example 3 before and after the heat treatment. As illustrated in Fig. 8, in the lead frame of Comparative Example 3, a large change in the surface morphology is observed in the plating layer after the heat treatment due to progress of recrystallization.

That is, in the semiconductor device using the lead frame of Comparative Example 3, there is a possibility that the peeling may occur between the plating layer and the sealing resin in the high temperature environment due to such a large change in the surface morphology. Therefore, there is a possibility that the reliability may be reduced in the high temperature environment.

Fig. 9 illustrates the surface morphology and the cross-sectional morphology of the plating layer formed on the lead frame of Example 2 before and after the heat treatment. As illustrated in Fig. 9, in the lead frame of Example 2, it is found that the surface morphology hardly changes even after the heat treatment.

Further, in the lead frame of Example 2 illustrated in Fig. 9, the aspect ratio before the heat treatment was 0.54. On the other hand, the aspect ratio after the heat treatment was 0.53. That is, in the lead frame of Example 2, it is found that the aspect ratio hardly changes even after the heat treatment.

As described above, the surface morphology of the lead frame of Example 2 does not change significantly even after thermal history is applied to the lead frame. Furthermore, the high aspect ratio of the protrusion is maintained. Therefore, it is possible to minimize the reduction in the adhesive strength between the sealing resin and the plating layer.

### <Evaluation 3>

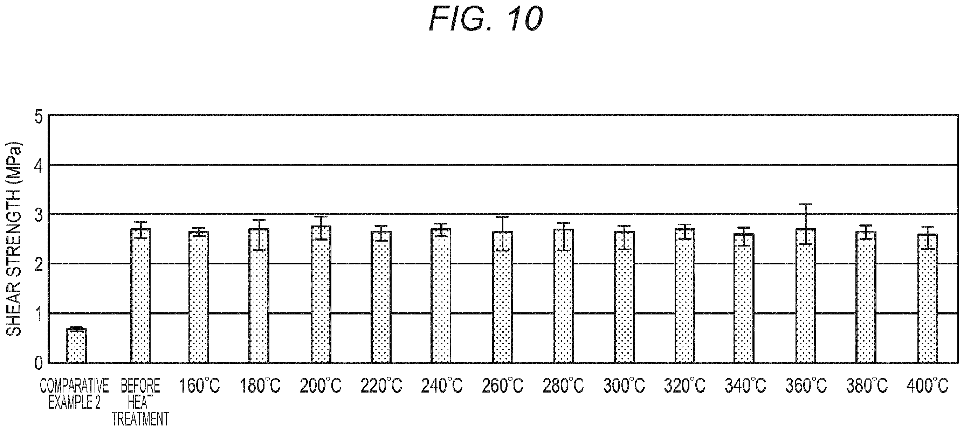

Next, variation of the shear strength when a measured temperature changed (that is, the variation of the shear strength when the thermal history applied to the lead frame changed) was evaluated. Specifically, the lead frame of Example 1 having the resin cup formed on the surface illustrated in Fig. 3 was held at a predetermined temperature in a range of 160°C to 400°C for 10 minutes, and then the shear strength of the lead frame was measured. Results are illustrated in Fig. 10.

Fig. 10 illustrates the variation of the shear strength according to the thermal history of the lead frame of Example 1. As illustrated in Fig. 10, in the lead frame of Example 1, it is found that the shear strength in thermal environments is maintained even when the thermal history is applied to the lead frame in the range of 160°C to 400°C.

Therefore, according to the present embodiment, even when the heat history is applied to the lead frame in the range of 160°C to 400°C, it is possible to minimize the reduction in the adhesive strength between the sealing resin and the plating layer.

### <Evaluation 4>

Next, assembly of the semiconductor device using the lead frames of Example 1 and Comparative Example 2 was evaluated. In addition, the reliability of the semiconductor device assembled using the lead frames of Example 1 and Comparative Example 2 was also evaluated. Results are shown in Table 1.

**[Table 1]**

| | | | | | | |
|---|---|---|---|---|---|---|
| **Assembly evaluation** | **Evaluation item** | **Standard** | **Comparative Example** | **2** | **Example 1** | |
| | **Paste wettability** | **Wettability > 90%** | **100%** | **PASS** | **100%** | **PASS** |
| | **EBO amount** | **EBO amount< 200µm** | **< 2.0µm** | **PASS** | **<110µm** | **PASS** |
| | **Recognition matching rate** | **Matching rate > 80%** | **> 90%** | **PASS** | **> 90%** | **PASS** |
| | **Die shear strength** | **Shear strength > 2.5kg** | **Min.39.7kg** | **PASS** | **Min.37.8kg** | **PASS** |
| | **Top pull strength** | **Pull strength >4.1g** | **Min.9.0g** | **PASS** | **Min.8.9g** | **PASS** |
| | **Stitch pull strength** | **Pull strength > 2.5g** | **Min.4.4g** | **PASS** | **Min.5.5g** | **PASS** |
| | **MOLD quality** | **No voids, no unfilled** | **All clear** | **PASS** | **All clear** | **PASS** |
| | **TRIM burr height** | **Burr height < 0.050mm** | **< 0.013mm** | **PASS** | **< 0.013mm** | **PASS** |
| | **FORM appearance** | **No clevis** | **All clear** | **PASS** | **All clear** | **PASS** |
| | **Initial SAT** | **No peeling** | **0/60pcs** | **PASS** | **0/60pcs** | **PASS** |
| **Reliability evaluation** | **Solder heat resistance test (MSL-2)** | **No peeling** | **30/30 pcs** | **FAIL** | **0/30pcs** | **PASS** |
| | **Solder heat resistance test (MSL-1)** | **No peeling** | **30/30pcs** | **FAIL** | **0/30pcs** | **PASS** |

As shown in Table 1, in assembly evaluation when the lead frame of Comparative Example 2 was used and assembly evaluation when the lead frame of Example 1 was used, good results were obtained in all items.

In general, in the stitch pull strength test using the lead frame having the surface with irregularities, a lower pull strength value is easily obtained. Regarding the pull strength of the stitch pull strength test, better results (Min. 5.5 g) were obtained from the lead frame of Example 1 having irregularities than from the lead frame of Comparative Example 2 having a smooth surface. Thus, according to the present embodiment, the semiconductor device can be assembled more stably.

Note that in the stitch pull strength test in the present disclosure, the pull strength was evaluated as follows. First, the bonding wire was bonded to the surface of the plating layer in a stitch shape. Next, a hook was hooked on this stitch-shaped bonding wire. In this way, a tensile test was performed at a rate of 170 µm/s. A tensile strength obtained in the tensile test was evaluated as a result of the stitch pull strength test.

Further, as shown in Table 1, good results were not obtained in reliability evaluation of the semiconductor device using the lead frame of Comparative Example 2. On the other hand, good results were obtained in the reliability evaluation of the semiconductor device using the lead frame of Example 1.

That is, the protrusion having the aspect ratio of 0.3 or more is formed on the surface of the plating layer used in the present embodiment. This can impart high reliability to the semiconductor device.

The present embodiment has been described above. However, the present embodiment is not limited to the above-described embodiment. Various modifications can be made to the above-described embodiment without departing from the gist of the present embodiment. For example, in the above embodiment, the plating layer containing Ag as the main component is exemplified. However, the present embodiment is not limited to such an example. The protrusion formed on the surface of the plating layer containing a noble metal element other than Ag as the main component may have the aspect ratio of 0.3 or more.

As described above, the metal component (lead frame 1) according to the present embodiment is used for manufacturing the semiconductor device. The metal component includes the substrate 2 and the noble metal plating layer (plating layer 3). The substrate 2 has a conductivity. The noble metal plating layer (plating layer 3) is formed on all or part of the surface of the substrate 2. Further, the noble metal plating layer (plating layer 3) has irregularities on the surface 3a. Then, the protrusion 3b of the irregularities has the aspect ratio of 0.3 or more. This can improve the reliability of the semiconductor device 100 in the high temperature environment.

Further, in the metal component (lead frame 1) according to the present embodiment, the noble metal plating layer (plating layer 3) contains Ag as the main component. This can improve the bonding strength between the lead frame 1 and the bonding wire 102. At the same time, the bonding strength between the lead frame 1 and the semiconductor element 101 can be improved.

Further, the protrusion 3b of the metal component (lead frame 1) according to the present embodiment has the aspect ratio of 0.5 or more. This can further improve the reliability of the semiconductor device 100 in the high temperature environment.

Other aspects of the present embodiment are not excluded by a particularly detailed or representative embodiment described above. Those skilled in the art can easily derive further effects and modifications of the present embodiment from the present disclosure. Accordingly, various modifications can be made to the above embodiment without departing from the spirit or scope of the comprehensive concept of the present embodiment as defined by the appended claims and their equivalents.

The foregoing detailed description has been presented for the purposes of illustration and description. Many modifications and variations are possible in light of the above teaching. It is not intended to be exhaustive or to limit the subject matter described herein to the precise form disclosed. Although the subject matter has been described in language specific to structural features and/or methodological acts, it is to be understood that the subject matter defined in the appended claims is not necessarily limited to the specific features or acts described above. Rather, the specific features and acts described above are disclosed as example forms of implementing the claims appended hereto.

## Claims

1. A metal component that is configured to be used for manufacturing a semiconductor device,
the metal component comprising:
a substrate having a conductivity; and
a noble metal plating layer formed on all or part of a surface of the substrate,
wherein the noble metal plating layer has a surface with irregularities, and
a protrusion of the irregularities has an aspect ratio of 0.3 or more.

2. The metal component according to claim 1, wherein the noble metal plating layer contains Ag as a main component.

3. The metal component according to claim 1, wherein the protrusion has an aspect ratio of 0.5 or more.

4. The metal component according to claim 2, wherein the protrusion has an aspect ratio of 0.5 or more.
